# FASCICULE DE BREVET EUROPEEN

(11) **EP 1 369 546 B1**
(45) Date de publication et mention de la délivrance du brevet: **24.08.2011**
(21) Numéro de dépôt: 03101527.4
(22) Date de dépôt: 27.05.2003
(51) Int. Cl.: E05B 65/20, H01Q 1/32, H05K 1/18

(54) **Module électronique flexible pour poignée d'ouvrant, notamment pour véhicule automobile**
Flexibles elektronisches Modul für einen Türgriff, insbesondere für ein Kraftfahrzeug
Flexible electronic module for door handle, in particular for motor vehicle

(30) Priorité: 07.06.2002 FR 0207169
(43) Date de publication de la demande: 10.12.2003
(73) Titulaire: VALEO ELECTRONIQUE, 94042 Creteil Cédex (FR)
(72) Inventeur: MUSAT, Ciprian, 94042, Créteil cedex (FR)
(74) Mandataire: Jacquot, Ludovic R. G.

(56) Documents cités:
- EP-A- 1 006 028
- EP-A- 1 058 338
- EP-A- 1 080 977
- DE-A- 4 035 526
- FR-A- 2 671 935
- FR-A- 2 754 416
- FR-A- 2 772 818
- US-A- 5 519 578
- US-A1- 2002 060 146

## Description

La présente invention est relative à un module électronique destiné à être intégré dans une poignée d'un ouvrant, notamment pour un véhicule automobile.

Il est connu d'intégrer une antenne d'émission et/ou de réception d'un signal électromagnétique dans une poignée d'ouvrant de véhicule dans le but de communiquer avec un identifiant porté par l'utilisateur en vue d'une authentification avant d'autoriser la décondamnation ou la condamnation du véhicule.

Dans le document EP 1 006 028, l'antenne intégrée dans la poignée est une antenne d'émission d'un signal d'interrogation, notamment constituée d'une bobine enroulée autour d'un noyau de ferrite. Lorsque l'identifiant reçoit le signal d'interrogation, il émet à son tour un signal de réponse destiné à être reçu par une autre antenne située sur le véhicule.

Dans le document FR 2 781 445, la poignée décrite intègre plusieurs antennes utilisées pour l'émission du signal d'interrogation et pour la réception du signal de réponse de l'identifiant.

Il est connu également d'intégrer dans une poignée d'ouvrant de véhicule un capteur de présence permettant de détecter la présence d'une main d'un utilisateur à proximité de ou sur la poignée, et permettre le déclenchement d'une interrogation à destination d'un identifiant. Ce capteur peut comporter, comme décrit dans le document EP 0 955 431, une antenne d'émission et une antenne de réception associées à un circuit de détection particulier, l'une des antennes pouvant en outre être utilisée pour l'interrogation de l'identifiant et/ou pour recevoir le signal de réponse de l'identifiant en vue de son authentification. En variante, il peut s'agir d'un capteur de type capacitif comprenant au moins une électrode située dans la poignée.

On s'intéresse ici plus particulièrement à la réalisation d'un module électronique comprenant l'une ou l'autre des fonctionnalités précédentes (communication avec un identifiant ou détection de présence), voire les deux fonctionnalités combinées, et qui soit adapté aux procédés de fabrication de grande cadence. Pour ce faire, il est intéressant de pouvoir proposer un module standard qui puisse s'intégrer à un grand nombre de poignées. Il faut cependant tenir compte de la grande diversité, sur le plan esthétique, des poignées, et tout particulièrement au fait que bon nombre de poignées présente un profil courbe. Le module électronique considéré doit donc pouvoir s'adapter aux spécificités des poignées, et notamment au rayon de courbure de la poignée dans laquelle il est destiné à être monté.

Ce but est atteint conformément à la présente invention, laquelle a pour objet un module électronique tel que défini dans la revendication 1.

D'autres caractéristiques de la présente invention apparaîtront au vu de la description suivante faite en référence aux figures annexées, dans lesquelles :

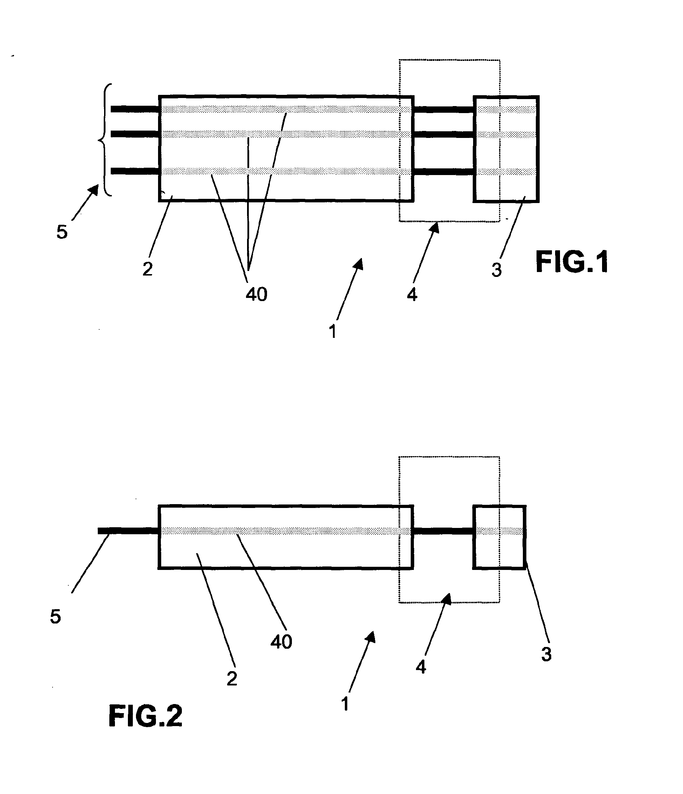

- la figure 1 représente schématiquement un module électronique selon la présente invention vu de dessus ;
- la figure 2 est une vue en élévation de ce même module.

Sur les figures, le module électronique 1 selon l'invention comporte deux parties rigides 2 et 3 reliées entre elles mécaniquement et électriquement par une zone flexible 4.

Dans un mode de réalisation préférentiel de l'invention, un tel module est obtenu par surmoulage d'une résine rigide sur une pièce métallique estampée sur deux zones situées de part et d'autre de la zone flexible 4. La pièce métallique est par exemple obtenue par la technique connue sous la terminologie anglo-saxonne du « lead-frame ». Sur les figures, on a représenté très schématiquement une telle pièce sous la forme de trois pistes 40. Avant surmoulage de la résine, les différents éléments composant le module auront été déposés, et maintenus par toute technique connue telle que la brasure ou le collage.

Le rôle de la résine est de protéger les divers éléments composant le module contre les agressions de l'environnement, tout en donnant la rigidité nécessaire au montage et au maintien du module au niveau de la poignée.

La résine doit notamment protéger les éléments contre :
- les efforts de montage ;
- le stress mécanique auquel le module peut être soumis à l'utilisation, particulièrement important dans le cas d'une poignée pour véhicule automobile ;
- les décharges électrostatiques ;
- l'humidité.

Au niveau de la zone flexible, on prévoit une absence de résine, de sorte que les deux parties rigides 2 et 3 sont maintenues entre elles uniquement par la partie de la pièce obtenue par lead-frame.

En variante, on peut prévoir de recouvrir cette zone flexible 4 par une résine afin d'assurer une protection contre les décharges électrostatiques. Cependant, cette résine devra être une résine souple, de manière à ne pas perdre en flexibilité.

Dans tous les cas, cette zone flexible permet au module de pouvoir s'adapter à différents rayons de courbure de poignées.

De manière préférentielle, on s'arrange pour regrouper tous les éléments formant un circuit électrique passif dans la première partie rigide 2, et les éléments formant le circuit électronique de contrôle et/ou de traitement au niveau de la seconde partie rigide 3.

Par exemple, la partie rigide 2 peut comporter, à l'intérieur de la résine rigide, une antenne constituée d'un noyau de ferrite allongé entouré d'un enroulement (non représentés), la deuxième partie rigide 3 renfermant le circuit contrôlant l'émission et/ou traitant les signaux reçus par l'antenne selon que cette antenne est une antenne d'émission ou d'émission/réception.

En variante ou en combinaison, la première partie rigide 2 peut renfermer les parties dites passives d'un capteur capacitif, à savoir les électrodes du capteur, l'électronique de contrôle de ce capteur (alimentation, traitement pour la détection de présence...) étant quant à elle localisée au niveau de la seconde partie 3.

Comme représenté sur les figures, on prévoit également qu'une zone 5 située à l'extrémité d'une des parties rigides (partie 2 sur les figures), opposée à la zone flexible 4 soit dépourvue de résine rigide, de manière à pouvoir servir de zone de connexion électrique du module électronique à tout équipement extérieur.

## Revendications

1. Module électronique (1) destiné à être intégré dans une poignée d'un ouvrant, notamment pour véhicule automobile, **caractérisé en ce qu'**il comporte au moins deux parties rigides (2, 3) reliées électriquement et mécaniquement entre elles par une zone flexible (4), chacune des parties rigides (2, 3) regroupant des éléments du modulé et une partie d'une pièce métallique estampée (40) sur laquelle sont déposés lesdits éléments, ladite pièce et les éléments étant enrobés sur deux zones de part et d'autre d'une zone correspondant à la zone flexible (4) à l'aide d'une résine rigide pour former les deux parties rigides (2, 3).

2. Module électronique (1) selon la revendication 1, **caractérisé en ce qu'**il comporte en outre une résine souple enrobant la zone flexible (4).

3. Module électronique (1) selon l'une quelconque des revendications précédentes, **caractérisé en ce qu'**une zone (5) de ladite pièce située à une extrémité d'au moins une des parties rigides opposée à la zone flexible (4) est dépourvue de résine et constitue une zone de connexion électrique du module.

4. Module électronique (1) selon l'une quelconque des revendications précédentes, **caractérisé en ce qu'**une première (2) des deux parties rigides regroupe des éléments formant un circuit électrique passif, la deuxième (3) partie rigide regroupant des éléments formant un circuit électronique de contrôle et/ou de traitement du circuit électrique passif.

5. Module électronique (1) selon la revendication 4, **caractérisé en ce que** la première partie rigide (2) comporte une antenne d'émission et/ou de réception, la deuxième partie rigide (3) comportant un circuit contrôlant l'émission de l'antenne et/ou traitant les signaux reçus par l'antenne.

6. Module électronique (1) selon la revendication 5, **caractérisé en ce que** ladite antenne comporte un noyau de ferrite autour duquel est placé un enroulement.

7. Module électronique (1) selon l'une quelconque des revendications 4 à 6, **caractérisé en ce que** la première partie rigide (1) comporte les électrodes d'un capteur capacitif de présence.

## Claims

1. Electronic module (1) designed to be incorporated into a door handle, in particular for a motor vehicle, **characterized in that** it comprises at least two rigid portions (2, 3) electrically and mechanically connected together by a flexible zone (4), each of the rigid portions (2, 3) combining elements of the module and a portion of a stamped metal part (40) onto which the said elements are placed, the said part and the elements being coated over two zones on either side of a zone corresponding to the flexible zone (4) with the aid of a rigid resin in order to form the two rigid portions (2, 3) .

2. Electronic module (1) according to Claim 1, **characterized in that** it also comprises a flexible resin coating the flexible zone (4).

3. Electronic module (1) according to either one of the preceding claims, **characterized in that** a zone (5) of the said part situated at one end of at least one of the rigid portions opposite to the flexible zone (4) is devoid of resin and forms an electrical connection zone of the module.

4. Electronic module (1) according to any one of the preceding claims, **characterized in that** a first portion (2) of the two rigid portions combines elements forming a passive electric circuit, the second rigid portion (3) combining elements forming an electronic circuit for the control and/or the processing of the passive electric circuit.

5. Electronic module (1) according to Claim 4, **characterized in that** the first rigid portion (2) comprises a transmit and/or receive antenna, the second rigid portion (3) comprising a circuit controlling the transmission of the antenna and/or processing the signals received by the antenna.

6. Electronic module (1) according to Claim 5, **characterized in that** the said antenna comprises a ferrite core around which a winding is placed.

7. Electronic module (1) according to any one of Claims 4 to 6, **characterized in that** the first rigid portion (2) comprises the electrodes of a capacitive presence sensor.

## Patentansprüche

1. Elektronisches Modul (1), dazu bestimmt, in einen Türgriff integriert zu werden, insbesondere für ein Kraftfahrzeug, **dadurch gekennzeichnet, dass** es mindestens zwei steife Teile (2, 3) aufweist, die elektrisch und mechanisch über eine elastische Zone (4) miteinander verbunden sind, wobei jedes der steifen Teile (2, 3) Elemente des Moduls und einen Teil eines gestanzten Metallbauteils (40) umfasst, auf dem die Elemente angeordnet sind, wobei das Bauteil und die Elemente in zwei Zonen zu beiden Seiten einer Zone entsprechend der elastischen Zone (4) mit Hilfe eines steifen Harzes umhüllt sind, um die zwei steifen Teile (2, 3) zu bilden.

2. Elektronisches Modul (1) nach Anspruch 1, **dadurch gekennzeichnet, dass** es außerdem ein die elastische Zone (4) umhüllendes weiches Harz aufweist.

3. Elektronisches Modul (1) nach einem der vorhergehenden Ansprüche, **dadurch gekennzeichnet, dass** eine Zone (5) des Bauteils, die sich an einem Ende mindestens eines der steifen Teile entgegengesetzt zur elastischen Zone (4) befindet, kein Harz aufweist und eine elektrische Verbindungszone des Moduls bildet.

4. Elektronisches Modul (1) nach einem der vorhergehenden Ansprüche, **dadurch gekennzeichnet, dass** ein erstes (2) der zwei steifen Teile Elemente umfasst, die eine passive elektrische Schaltung bilden, während das zweite steife Teil (3) Elemente umfasst, die eine elektronische Steuer- und/oder Verarbeitungsschaltung der passiven elektrischen Schaltung bilden.

5. Elektronisches Modul (1) nach Anspruch 4, **dadurch gekennzeichnet, dass** das erste steife Teil (2) eine Sende- und/oder Empfangsantenne aufweist, während das zweite steife Teil (3) eine Schaltung aufweist, die das Senden der Antenne steuert und/oder die von der Antenne empfangenen Signale verarbeitet.

6. Elektronisches Modul (1) nach Anspruch 5, **dadurch gekennzeichnet, dass** die Antenne einen Ferritkern aufweist, um den eine Wicklung angeordnet ist.

7. Elektronisches Modul (1) nach einem der Ansprüche 4 bis 6, **dadurch gekennzeichnet, dass** das erste steife Teil (2) die Elektroden eines kapazitiven Anwesenheitssensors aufweist.
